# EUROPEAN PATENT SPECIFICATION

(11) **EP 2 503 589 B1**
(45) Date of publication and mention of the grant of the patent: **11.01.2017**
(21) Application number: 12002005.2
(22) Date of filing: 21.03.2012
(51) Int. Cl.: H01L 21/36, H01L 31/0248, H01L 31/032

(54) **Multi-stage formation of thin-films for photovoltaic devices**
Mehrstufige Bildung von Dünnfilmen für Fotovoltaikvorrichtungen
Formation de couches minces multi-niveaux pour dispositifs photovoltaïques

(30) Priority: 21.03.2011 US 201113052618
(43) Date of publication of application: 26.09.2012
(73) Proprietor: Sunlight Photonics Inc., South Plainfield, NJ 07080 (US)
(72) Inventor: Frolov, Sergey, Murray Hill, NJ 07974 (US); Bruce, Allan, James, Scotch Plains, NJ 07076 (US); Cyrus, Michael, Summit, NJ 07901 (US)
(74) Representative: Hauck Patentanwaltspartnerschaft mbB

(56) References cited:
- WO-A1-2011/115894
- US-A1- 2009 250 722
- US-A1- 2010 015 754
- US-A1- 2010 081 230
- US-A1- 2010 108 503
- NAKADA T ET AL: "CUINSE2-BASED SOLAR CELLS BY SE-VAPOR SELENIZATION FROM SE- CONTAINING PRECURSORS", SOLAR ENERGY MATERIALS AND SOLAR CELLS, ELSEVIER SCIENCE PUBLISHERS, AMSTERDAM, NL, vol. 35, no. 1/04, 1 September 1994 (1994-09-01), pages 209-214, XP000737071, ISSN: 0927-0248, DOI: 10.1016/0927-0248(94)90142-2
- A. ROMEO ET AL: 'Development of thin-film Cu(In,Ga)Se2 and CdTe solar cells' PROGRESS IN PHOTOVOLTAICS: RESEARCH AND APPLICATIONS vol. 12, no. 23, 01 March 2004, pages 93 - 111, XP055024654 DOI: 10.1002/pip.527 ISSN: 1062-7995

## Description

### Field

The present invention relates to a method for forming a compound material thin film, such as a semiconductor thin-film suitable for use in photovoltaic solar cells and other devices.

### Related art

One of the major contributors to current worldwide generation of renewable energy is the solar energy produced via a photovoltaic (PV) effect. PV-based renewable-energy sources generate energy, in the form of electricity, by harnessing electromagnetic radiation, such as sunlight. PV applications are not limited to any particular area of the world and/or any given sector of the economy. In remote regions of the world, for example, an off-grid installation of the PV source provides the only available source of electricity. In highly populated and/or economically developed regions, the PV source may, for example, source electricity to an electrical grid to supplement and/or reduce the amount of conventional energy distributed from the electrical grid. A PV source is in general any electric system containing a PV device, such as a PV cell or a PV module.

PV devices are frequently used to convert optical energy into electrical energy. Typically, a photovoltaic device is made of one or two semiconductors with p-doped and n-doped regions. The commercialization of PV devices depends on technological advances that lead to higher efficiencies and lower cost of such devices. The cost of electricity can be significantly reduced by using PV devices constructed from compound thin film semiconductors, such as copper indium gallium selenide (CIGS).

Several techniques have been developed for producing thin-film PV materials. Thin films of alloys based on amorphous silicon can be produced using chemical vapor deposition (CVD). CdTe films may be manufactured in a number of different ways, which include electro-deposition and vapor transport deposition. The CVD process is relatively expensive and not suitable for compound semiconductors, such as CIGS. Less expensive techniques developed for CdTe are also not applicable for other thin-film PV materials. CIGS films are mainly made using either an elemental co-evaporation process or a two-stage process, in which sputtering of a precursor film is followed by its selenization. The two-stage process is relatively easier to scale up in volume in comparison with the co-evaporation process, but is has drawbacks, such as loss of adhesion between the absorber layer and the back contact layer during selenization.

From US 2010/0081230 A1 a method and structure for adhesion of absorber material for thin film photovoltaic cells has become known. The method includes forming a copper layer overlying a thin, intermediary adhesive layer and forming an indium layer overlying the copper layer to form a multilayer structure and subjecting the multilayer structure to a thermal treatment process with a sulfur bearing species to form a copper indium disulfide alloy material.

US 2009/0250722 A1 discloses a method for producing a thin-film semiconductor device using a process named Reacted Target Physical Deposition (RTPD) in which a plurality of raw semiconductor materials undergoes a pre-reacting process to form a homogeneous compound semiconductor target material.

US 2010/0108503 A1 describes the fabrication of a sputter target structure for depositing semiconducting chalcogenide films via ingot or powder metallurgy, wherein the sputter target includes a target body comprising at least one chalcogenide alloy with a high purity.

### Summary

In accordance with one aspect of the invention, a method is provided for producing a film of compound material. The method includes the process steps according to claim 1.

### Brief description of drawings

FIG.1 shows a process for producing a thin-film solar cell.
FIG.2 shows a substrate configuration of a thin-film solar cell
FIG.3 shows a superstrate configuration of a thin-film solar cell
FIG.4 shows a multi-stage formation of a binary compound thin-film.
FIG.5 shows a multi-stage formation of a ternary compound thin-film.
FIG.6 shows a multi-stage formation of a CIGS compound thin-film.
FIG.7 shows a process for depositing a CIGS* film.
FIG.8. shows a selenization process of a CIGS* film.

### Detailed description

In the following detailed description, numerous specific details are set forth in order to provide a thorough understanding of exemplary embodiments or other examples described herein. However, it will be understood that these embodiments and examples may be practiced without the specific details. In other instances, well-known methods, procedures, components and circuits have not been described in detail, so as not to obscure the following description.

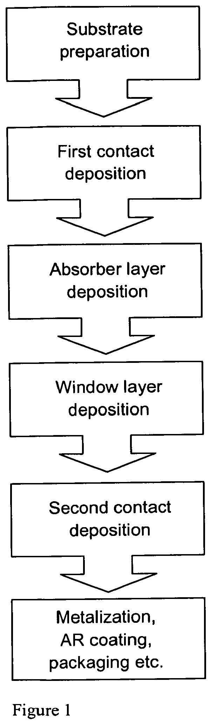

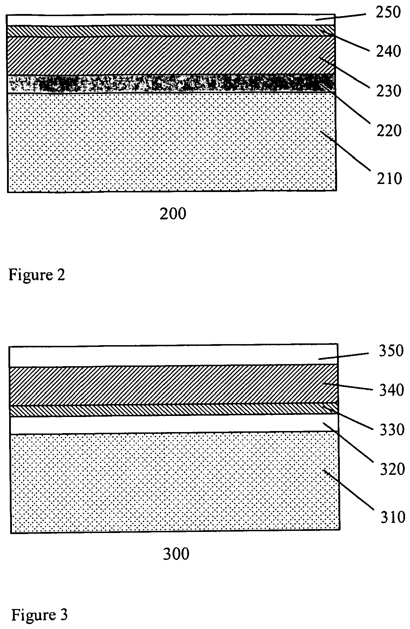

FIG.1 illustrates an example of a process for manufacturing the thin-film photovoltaic (PV) device 200 shown in FIG.2. This process includes several steps starting with the substrate preparation. Substrate 210 may be a glass sheet, a metal foil or a plastic film. First contact layer 220 may be deposited onto substrate 210 using a sputtering process. The first contact may serve as the back contact and contain metals, such as molybdenum (Mo), or transparent conducting oxides (TCO), such as tin oxide (SnO₂). The next optional processing step may include a laser scribing process, in which the first contact layer is divided into several electrically disconnected regions that in turn define individual PV cells. Subsequently, a thin absorber layer 230 is deposited on top of the first contact layer 220 using a multi-stage deposition process, which will be described in detail below. The absorber material may be based on CIGS, CdTe, a-Si, organic semiconductors and other thin-film semiconductors. A thin layer of another semiconductor material may be then deposited by a sputtering process, for instance, to produce a window layer 240, thus forming a pn junction with the absorber layer 230 underneath. Additional optional processing may include a mechanical scribing process, in which the absorber and window layers are divided into several electrically disconnected regions that in turn define individual PV cells. Subsequent to these steps, a second contact layer 250 is produced to create a functioning PV device 200. The second contact may serve as the front contact and contain TCO, such as indium tin oxide (ITO) or Al-doped zinc oxide (AZO). In addition, this manufacturing process may include various subsequent steps such as additional mechanical scribing, deposition of metal grid contacts, anti-reflection coating, lamination, packaging, etc.

The manufacturing process of FIG.1 may be modified to produce the thin-film PV device 300 illustrated in FIG.3. In the modified process the window layer deposition precedes the absorber layer deposition. In this case, PV device 300 includes substrate 310, first contact layer 320, window layer 330, absorber layer 340, and second contact 350. The first contact may serve as the front contact and the second contact may serve as the back contact.

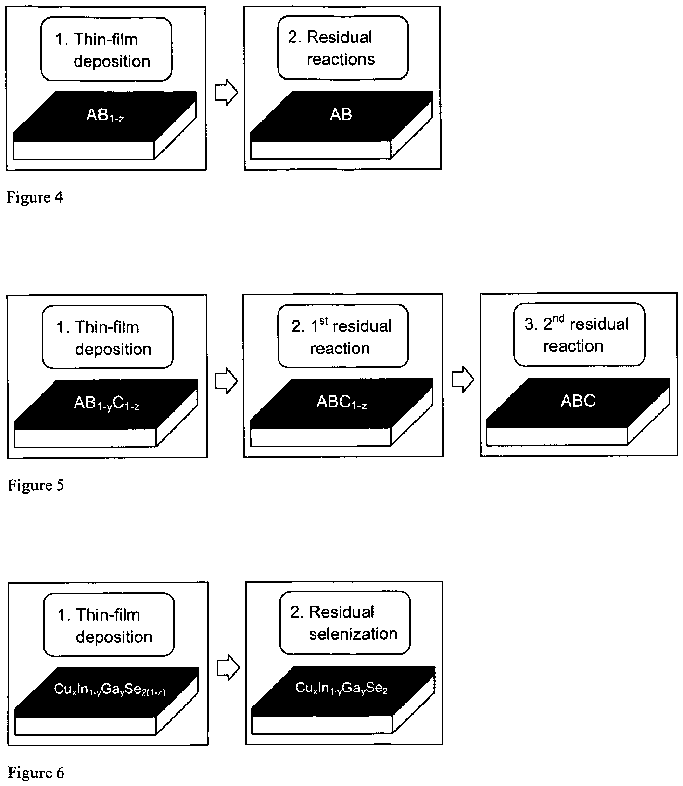

As previously mentioned, absorber layers 230 and 340 may be formed using a multi-stage process, an example of which is shown in FIG.4. First, a film is produced with a chemical composition AB_{1-z}, which may be similar or close to the chemical composition of a compound PV semiconductor AB, where A and B are different chemical elements and A may also be an alloy of different chemical elements. The value of *(1-z)*, where z is the chemical deficiency of element B, can be defined as the ratio between the initial element B content to the final element B content; z may be in the range of 0.05 to 0.95, preferably in the range of 0.15-0.4.

It is generally preferable for the compound semiconductor AB to be sufficiently stoichiometric and thus have a single phase crystalline structure at room temperature. On the other hand, the compound material AB_{1-z} may be non-stoichiometric and thus contain different crystalline phases. In the latter case the composition AB_{1-z} refers to the composition averaged across the volume of the deposited thin film. Compound material AB_{1-z} may also differ from the compound semiconductor AB in its physical properties, e.g. it may be an electrical conductor rather than a semiconductor.

Compound material AB_{1-z} in the film may be a mixture of its constituent elements, e.g. a mixture of fine powders of elements A and B, respectively, wherein the characteristic particle size may be less than one micron, preferably in the range of 5-50 nm. It is preferable however that the compound material AB_{1-z} is a fully reacted, chemically stable material that is not just a mixture of its constituent elements. In this material chemical bonds are formed between its different elements and its chemical composition and crystalline structure may be substantially homogeneous from large to very small scales (∼few nm).

In the first step shown in FIG. 4 a thin film comprising semiconductor AB_{1-z} may be deposited according the present invention by a sputtering process. For example, a pre-reacted bulk material having chemical composition AB_{1-z} may be dispersed and deposited onto a substrate in the form of a thin film with substantially the same chemical composition AB_{1-z}. In the second step, a residual chemical reaction process is induced in the film when it is placed in an atmosphere of vapor containing element B. As result of the chemical reaction, a PV absorber film is produced with the chemical composition AB.

This aforementioned process is also applicable to compound semiconductor materials comprising more than two constituent chemical elements. For example, in the case of a ternary semiconductor film a film having chemical composition ABC_{1-z} is first deposited onto a substrate. Afterwards, a residual chemical reaction is used to change the chemical composition of the film to ABC. Chemical elements A, B and C may be, for example, chemical elements from groups I, III and VI, respectively. Group I elements include such elements as Cu, Ag and Au, group III elements include Al, In, Ga and Tl, whereas group VI elements include S, Se and Te. In this case the compound semiconductor ABC may be, for example, CuInSe₂. In addition, chemical elements from other groups may be used, e.g. Sn from group IV.

Similarly, the multi-stage process described above may be used with quaternary semiconductors and other materials comprising more than four elements. For instance, in the above example of the ternary compound semiconductor CuInSe₂, chemical elements from either group I, group III or group VI may be partially substituted with different elements from the same group. For example, Cu may be partially substituted with Ag, In may be partially substituted with Ga, and Se may be partially substituted with S. Such substitution does not alter the basic crystalline structure of the material and therefore does not produce any associated crystalline defects. It is frequently used to change electronic and optical properties of the material, e.g. to increase the optical bandgap in CuInSe₂ one may substitute In fully or partially with Ga.

The multi-stage formation process is particularly applicable to compound semiconductor materials comprising more than two constituent chemical elements. For the formation of compound materials having multiple constituent elements with compositional deficiencies, the multi-stage process may include multiple residual reaction steps each corresponding to a specific deficient element. For example, in the case of a ternary compound material film a film having an initial chemical composition AB_{1-y}C_{1-z} is first deposited onto a substrate, where elements B and C are deficient. Subsequently, several residual chemical reaction steps are used to change the chemical composition of the deposited film to ABC as shown in FIG.5. In the first residual reaction step, an additional quantity *y* of element B is provided to produce a film with an intermediate composition ABC_{1-z}. In the second residual reaction step, an additional quantity z of element C is provided to produce a film with the final composition ABC. It also may be possible to combine multiple residual reactions in a single processing step, where more than a single element is added to the chemical composition (e.g. B and C in the above example).

FIG.6 shows an example of a multi-stage formation process that employs a CIGS film. In the first step, a thin CIGS* film is produced with a chemical composition CuₓIn_{1-y}Ga_{y}Se_{2(1-z)}, which is close to the chemical composition of a compound PV semiconductor CuₓIn_{1-y}Ga_{y}Se₂. The Cu content x may be in the range of 0.6 to 1.0, and preferably in the range of 0.8-0.95. The Ga content *y*, which determines the CIGS optical bandgap, may be in the range of 0.1-1.0, and preferably in the range of 0.2-0.35. The Se deficiency z may be in the range of 0.1-0.9, and preferably in the range of 0.5- 0.85. In the second step. A residual selenization process is used to induce additional chemical reactions in the deposited film to thereby adjust the chemical composition of the film so that it has the composition CuₓIn_{1-y}Ga_{y}Se₂.

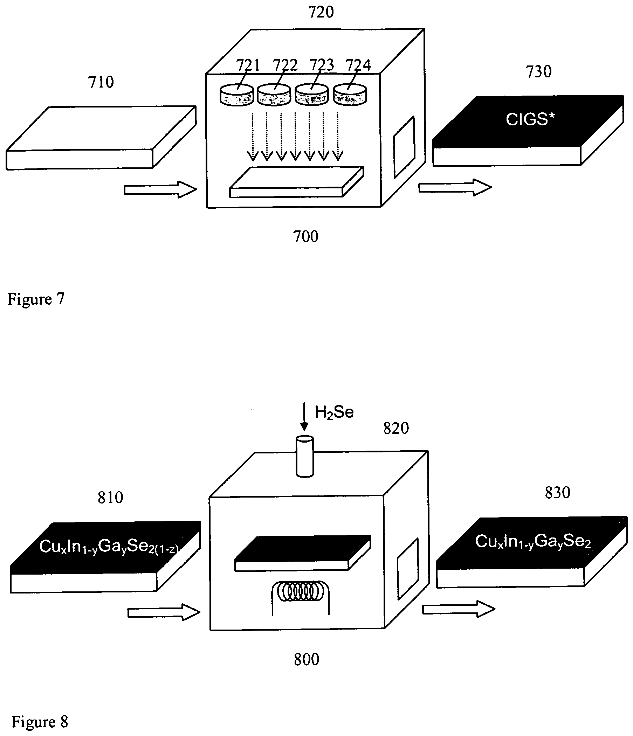

FIG.7 shows schematically a method for the deposition of CIGS* thin films. The CIGS* film may be deposited by sputtering from one or more targets (721, 722, 723 and 724). Target materials include fully reacted compounds, such as CuₓIn_{1-y}Ga_{y}Se_{2(1-z)}. In this deposition process a flat rigid substrate 710 may be used that has been prepared and processed prior to the deposition as described above. Alternatively, in a roll-to-roll deposition system a flexible substrate may be used. A vacuum deposition system 720 may employ, for example, a magnetron sputtering tool to deposit a thin CIGS* film 730 on the substrate. DC magnetron sputtering may be used for electrically conductive targets such as metallic alloys, which is a faster process compared to the RF sputtering that is normally used with dielectrics.

FIG.8 shows schematically a method for the residual selenization step, in which a thin CIGS* film on a substrate 810 having the initial composition CuₓIn_{1-y}Ga_{y}Se_{2(1-z)} is first transported into a chamber 820. Se-containing gas, such as H₂Se or Se₂, is delivered to chamber 820 and the film on the substrate 810 is heated. Under these conditions, Se atoms diffuse into the film to complete the formation of the CIGS film 830, which has the final composition CuₓIn_{1-y}Ga_{y}Se₂. The chemical reaction may be controlled by temperature and time. For example, residual selenization may be accomplished using temperatures in the range from 400°C to 550°C and a reaction time in a range of 5 to 30 minutes. The reaction time may be chosen to allow a sufficient amount of Se (in proportion to Se deficiency) to diffuse and react with the rest of the elements in the film. Selenization and other similar reactions, such as for example sulfurization, under appropriate conditions of temperature and pressure may be self-limiting. This implies that upon the formation of a stoichiometric compound of CuₓIn_{1-y}Ga_{y}Se₂, further incorporation of Se into the film stops and the selenization reaction terminates. An example of appropriate conditions for such a self-limiting reaction may be a sufficiently high processing temperature, at which chalcogens, which are in excess to the stoichiometry and not chemically bound with other film constituents, can exhibit a significant partial vapor pressure and may preferentially be lost from the film through vaporization. This is particularly convenient in large scale manufacturing, where processes requiring less control are less expensive, more reliable and thus more attractive. After residual selenization, the CIGS film is fully reacted, forming a chalcopyrite polycrystalline structure with a minimal amount of crystalline defects associated with deficiencies of its constituent elements (Se in particular).

In accordance with the present invention, the multi-stage thin film deposition process may be applied to a variety of other compound materials. Examples include:
1. **CuₓIn_{1-y}Ga_{y}S_{2z}Se_{2(1-z)}**. First, a thin film is produced in a PVD process with a chemical composition CuₓIn_{1-y}Ga_{y}S_{2z}Se_{2(1-z1)}. Cu content x may be in the range of 0.6 to 1.0, preferably in the range of 0.8-0.95. Ga content *y* may be in the range of 0.05-1.0, preferably in the range of 0.1-0.3. S content z may be in the range of 0.0-1.0, whereas Se deficiency *z1* may be in the range of 0.1-1.0 so that *z1*>*z.* Second, a residual selenization process is used to adjust the chemical composition of the film to CuₓIn_{1-y}Ga_{y}S_{2z}Se_{2(1-z)}. For this compound either residual selenization, sulfurization or a combination of the two processes (e.g. employing vapors of both S₂ and Se₂) may be used in the last stages of the deposition process.
2. **Cuₓ₁Agₓ₂Ga_{1-y}S_{y}Se₂**. First, a thin film is produced in a PVD process with a chemical composition Cuₓ₁Agₓ₂In_{1-y}Ga_{y}Se_{2(1-z)}. Cu content *x1* and Ag content *x2* may be in the range of 0.1 to 1.0, so that *x1*+*x2*<1*.* Ga content *y* may be in the range of 0.05-1.0, preferably in the range of 0.1-0.35. Se deficiency z may be in the range of 0.1-0.9, preferably in the range of 0.5-0.85. Second, a residual selenization process is used to adjust the chemical composition of the film to Cuₓ₁Agₓ₂In_{1-y}Ga_{y}Se₂.

These and other suitable compound materials may also include minor dopants that have relatively small concentrations and thus do not significantly alter the overall chemical composition and the associated crystalline structure. For example, CIGS compounds may include 0.01-0.3 at.% of sodium (Na), which facilitates grain growth in CIGS films and also improves their electrical properties. In this case Na may be added to the bulk material and then transferred to the film with other CIGS elements during deposition. Also, in the initial deposition of a thin-film its constituents may include temporary chemical elements that may be removed from the film during subsequent processing steps. For example, such a deposition process may involve one of the oxide compounds, i.e. CuO, In₂O₃ and Ga₂O₃, where oxygen may be later removed by chemical reduction using hydrogen gas.

The multi-stage thin film formation process provides several advantages over the existing film forming processes. Residual chemical reactions in the deposited film enable more flexible control of the film's morphology. Specifically, they promote polycrystalline grain growth and grain fusing. The volumetric expansion of the film associated with these chemical reactions removes pinholes and improves intergrain electrical transport. It is also known that the interlayer adhesion may be compromised by the film's exposure to the high temperatures typically required by chemical reactions in the existing deposition processes. The multi-stage process can improve the adhesion between the absorber layer and the first contact layer by substantially reducing the amount of chemical reactions required in the film after deposition.

## Claims

1. A method for producing a film of compound material comprising the steps of providing a substrate;
depositing a film on the substrate using a fully reacted material, wherein the deposited film and the fully reacted material have a first chemical composition that includes at least one first chemical element and at least one second chemical element;
wherein said step of depositing the film comprises the steps of preparing the fully reacted material from said at least one first chemical element and said at least one second chemical element, forming at least one sputtering target from the fully reacted material and sputtering the fully reacted material onto the substrate;
wherein said first chemical composition comprises Cu, In, Ga and Se and wherein said at least one second chemical element is selected from Se, S and Te;
the fully reacted material being pre-reacted to form chemical bonds between the different chemical elements;
inducing at least one chemical reaction in the deposited film using a source containing the at least one second chemical element to thereby increase the content of at least one second chemical element in the deposited film so that the deposited film has a second chemical composition; wherein the content of the at least one second chemical element in the second chemical composition is larger than the content of the at least one second chemical element in the first chemical composition to produce a stoichiometric film having a single crystalline phase.

2. A method of claim 1 wherein said at least one second chemical element comprises a plurality of chemical elements.

3. A method of claim 1 wherein said substrate comprises a first contact layer.

4. A method of claim 1 wherein the content of the at least one second chemical element in the second chemical composition is larger than the content of the at least one second chemical element in the first chemical composition by at least 10%.

5. A method of claim 1 wherein said at least one chemical reaction is produced at a temperature of at least 400°C.

6. A method of claim 1 wherein said the step of inducing at least one chemical reaction includes exposing the film to a vapor that includes the at least one second chemical element.

## Patentansprüche

1. Verfahren zur Herstellung einer Schicht aus Verbundmaterial umfassend die Schritte:
Bereitstellen eines Substrats;
Abscheiden einer Schicht auf dem Substrat unter Verwendung eines vollständig reagierten Materials, wobei die abgeschiedene Schicht und das vollständig reagierte Material eine erste chemische Zusammensetzung aufweisen, die mindestens ein erstes chemisches Element und mindestens ein zweites chemisches Element umfasst;
wobei der Schritt des Abscheidens der Schicht die Schritte umfasst: Anfertigen des vollständig reagierten Materials aus dem mindestens einen ersten chemischen Element und dem mindestens einen zweiten chemischen Element, Formen von mindestens einem Sputtertarget aus dem vollständig reagierten Material und Sputtern des vollständig reagierten Materials auf das Substrat;
wobei die erste chemische Zusammensetzung Cu, In, Ga und Se umfasst und wobei das mindestens eine zweite chemische Element aus Se, S und Te gewählt wird;
wobei das vollständig reagierte Material zum Ausbilden chemischer Verbindungen zwischen den unterschiedlichen chemischen Elementen vorreagiert ist;
Einleiten mindestens einer chemischen Reaktion in der abgeschiedenen Schicht unter Verwendung einer das mindestens eine zweite chemische Element beinhaltenden Quelle, um dadurch den Gehalt des mindestens einen zweiten chemischen Elements in der abgeschiedenen Schicht zu erhöhen, so dass die abgeschiedene Schicht eine zweite chemische Zusammensetzung aufweist;
wobei der Gehalt des mindestens einen ersten chemischen Elements in der zweiten chemischen Zusammensetzung größer ist als der Gehalt des mindestens einen zweiten chemischen Elements in der ersten chemischen Zusammensetzung, um eine stöchiometrische Schicht mit einer einkristallinen Phase herzustellen.

2. Verfahren nach Anspruch 1, wobei das mindestens eine zweite chemische Element eine Vielzahl von chemischen Elementen umfasst.

3. Verfahren nach Anspruch 1, wobei das Substrat eine erste Kontaktschicht umfasst.

4. Verfahren nach Anspruch 1, wobei der Gehalt des mindestens einen zweiten chemischen Elements in der zweiten chemischen Zusammensetzung um mindestens 10 % größer ist als der Gehalt des mindestens einen zweiten chemischen Elements in der ersten chemischen Zusammensetzung.

5. Verfahren nach Anspruch 1, wobei die mindestens eine chemische Reaktion bei einer Temperatur von mindestens 400 °C stattfindet.

6. Verfahren nach Anspruch 1, wobei der Schritt des Einleitens der mindestens einen chemischen Reaktion ein Aussetzen der Schicht gegenüber einem Dampf, der das mindestens eine zweite chemische Element umfasst, einschließt.

## Revendications

1. Procédé de production d'un film de matériau composite, comprenant les étapes de mise à disposition d'un substrat ;
dépôt d'un film sur le substrat à l'aide d'un matériau totalement activé, dans lequel le film déposé et le matériau totalement activé présentent une première composition chimique incluant au moins un premier élément chimique et au moins un deuxième élément chimique ;
dans lequel l'étape de dépôt du film comprend les étapes de préparation du matériau totalement activé à partir dudit au moins un premier élément chimique et dudit au moins un deuxième élément chimique, de formation d'au moins une cible de pulvérisation à partir du matériau totalement activé, et de pulvérisation du matériau totalement activé sur le substrat ;
dans lequel ladite première composition chimique comprend du Cu, de l'In, du Ga et du Se et dans lequel ledit au moins un deuxième élément chimique est choisi parmi le Se, le S et le Te ;
le matériau totalement activé étant pré-activé pour former des liaisons chimiques entre les différents éléments chimiques ;
l'induction d'au moins une réaction chimique dans le film déposé, à l'aide d'une source contenant l'au moins un deuxième élément chimique, pour ainsi augmenter la teneur du film déposé en au moins un deuxième élément chimique de manière à ce que le film déposé présente une deuxième composition chimique ; la teneur de la deuxième composition chimique en l'au moins un deuxième élément chimique étant supérieure à la teneur de la première composition chimique en l'au moins un deuxième élément chimique, afin de produire un film stoechiométrique présentant une seule phase cristalline.

2. Procédé selon la revendication 1, dans lequel ledit au moins un deuxième élément chimique comprend une pluralité d'éléments chimiques.

3. Procédé selon la revendication 1, dans lequel ledit substrat comprend une première couche de contact.

4. Procédé selon la revendication 1, dans lequel la teneur de la deuxième composition chimique en l'au moins un deuxième élément chimique est supérieure d'au moins 10% à la teneur de la première composition chimique en l'au moins un deuxième élément chimique.

5. Procédé selon la revendication 1, dans lequel ladite au moins une réaction chimique est produite à une température d'au moins 400°C.

6. Procédé selon la revendication 1, dans lequel ladite étape d'induction d'au moins une réaction chimique comprend l'exposition du film à une vapeur incluant l'au moins un deuxième élément chimique.
